# EUROPEAN PATENT APPLICATION

(11) **EP 3 263 216 A1**
(43) Date of publication of application: **03.01.2018**
(21) Application number: 16183120.1
(22) Date of filing: 05.08.2016
(51) Int. Cl.: B01L 3/00, G01R 33/12, G01R 33/09

(54) **SENSING DEVICE AND METHOD**

(30) Priority: 27.06.2016 PT 16141870
(71) Applicant: Magnomics, SA, 3060-197 Cantanhede (PT)
(72) Inventor: ARROYO CARDOSO, Filipe, 1050-227 LISBOA (PT); BAIAO MARTINS ROMAO, VERONICA CRISTINA, 2815-881 SOBREDA (PT)
(74) Representative: Thorniley, Peter

(57) **Abstract**

A device and method are provided that allow a droplet of solution to be well controlled on a sensor region. One or more sensor structures are disposed above the substrate of the device, each sensor structure being disposed within an associated sensor region of the device. Further provided are one or more frames, each frame surrounding an associated sensor region and being formed of a material having a second wettability lower than a first wettability of at least part of the surface of the device within the frame.

## Description

### Field

The present disclosure relates to sensors, and particularly, but not exclusively, to integrated circuit sensors for sensing properties of analyte solutions.

### Background

There is an ongoing desire to improve the availability and efficiency of testing apparatuses in general. One example of this is in the field of biological testing. Part of the process of improvement relates to miniaturisation of the apparatus to make it portable and thus usable in a wide range of circumstances. As a result, "lab-on-chip" approaches have been developed to biological assays.

These approaches provide an integrated circuit comprising the relevant sensor technology and other circuitry. For instance, one approach involves binding biological molecules to magnetisable particles, and subsequent detection of the molecules through the application of a magnetic field. In this case, the integrated circuit (or chip) may carry sensor technology (such as a giant magnetoresistive sensor) capable of identifying small perturbations in a magnetic field.

The magnetic field provides the bridge between the biological/molecular sample under test and the electrical output which provides measurable results. However, there are geometric or physical constraints to the effective operation of such a test, in that the molecules to be analysed must be in physical proximity to the sensor.

To mediate the proximity of the analyte to the sensor, a bioreceptor (probe molecule) designed to interact with the specific analyte of interest is deposited upon the surface of a sensor chip above the sensor itself.

In practice, a droplet of a solution containing the molecules to be confined on the surface is dispensed over the sensor region. In many cases, the chip will comprise an array of sensors, meaning that an array of corresponding droplets are deposited above each sensor. The spotting of the solution over the surface of the device is normally a noncontact process to avoid damage due to contact/abrasion on the surface, particularly where the surface is biochemically functional (e.g. provides linker molecules designed to bind to the molecules within the solution). This implies that droplets are released on the surface from a distance.

As a result, droplet scattering, dispersion and spreading issues can arise due to:
i) droplet scattering from the target spot caused by surface topography, hydrophobicity/hydrophilicity surface gradients, surface cleanliness issues;
ii) droplet dispersion due to surface topography, structures of different heights;
iii) droplet spreading creating large spot areas and faster evaporation, leading to heterogeneous surface density of biochemical layer;
iv) coalescence of contiguous droplets lead to spot contamination and crossreactivity problems.

One approach to these issues, described in "Controlling Microarray Spot Morphology with Polymer Lift-off Arrays" by Mirabal et al (Anal Chem. 2007 February 1; 79(3): 1109-1114) provides a patterned structure on the surface of the chip. An array of openings are provided in a polymer "lift-off" layer so that each droplet covers multiple openings. The openings thus define "sub-spots" relative close to the chip surface, with the concentration and volume of solution in each sub-spot more consistent than that for the spot as a whole.

While this approach may provide some benefits in respect to the development of heterogeneous biochemical densities, it does not prevent problems at the scale of the droplet itself such as dispersion due to surface topography, scattering or coalescence of contiguous droplets. Each of these problems inhibits further miniaturisation and the efficiency of the sensing apparatus as a whole. There is therefore an ongoing desire to address these issues.

### Summary

According to a first aspect of the disclosure, there is provided a sensing device, comprising
a substrate;
one or more sensor structures disposed above the substrate, each sensor structure being disposed within an associated sensor region of the device; and
one or more frames, each frame surrounding an associated sensor region and having a second wettability lower than a first wettability of at least part of the surface of the device within the frame.

According to a second aspect of the disclosure, there is provided method for locating a solution above a sensor structure, the method comprising:
providing a sensing device comprising:
   a substrate;
   one or more sensor structures disposed above the substrate, each sensor structure being disposed within an associated sensor region of the device; and
   one or more frames, each frame surrounding a sensor region and having a second wettability lower than a first wettability of at least part of the surface of the device within the frame,
wherein the method further comprises depositing a droplet of the solution on the surface of the sensing device within each frame.

These aspects can help to maintain the integrity and consistency of a droplet of solution, since the frame of lower wettability will effectively act as a barrier to the spreading of the droplet. The surface of the device within the frame comprises at least a part with a higher wettability than the frame itself; in preferred embodiments, the wettability of the frame may be lower than the surface of the device within the frame and adjacent to the frame or than all the surface of the device within the frame. By adopting a different wettability, there is no requirement to rely upon a geometric constraint (i.e. a barrier of comparable height to the droplet) meaning that the approach does not imply significant weight, size or cost disadvantages. Moreover, by constraining the droplet as a whole, dispersion due to topography or interaction of adjacent droplets can be prevented.

The wettability relates to the nature of the liquid of the droplet. As such, where the droplet is aqueous, a material of a lower wettability will have a greater hydrophobicity. However, where the solution is not aqueous the relative values of hydrophobicity and wettability may not be correlated in the same way.

In a preferred embodiment, the device comprises a plurality of sensor structures and a plurality of frames. Droplets may be independently deposited within each frame. For example, droplets comprising different probe molecules may be provided above each sensor structure. As such, a later analyte solution applied across the sensor structures may be analysed for the presence of different molecules. Alternatively, different analyte solutions can be provided above each sensor structure, for example.

Preferably, each sensor region has an area of at least 100um², more preferably at least 10000um². The largest dimension of the sensor region may be in the range 10um to 500um, and in preferred embodiments is in the range 100um to 300um. This can assist in enabling individual droplets to be deposited entirely within the frame.

In preferred embodiments, there may be provided a passivation layer. The passivation layer may be disposed above the sensor structure. The frame or frames may be disposed upon the passivation layer. The passivation layer may have a substantially constant thickness. Depositing a layer of constant thickness is relatively efficient and reduces complexities in the manufacturing process. Although this may leave variations in surface topology (for example, due the partial presence of the sensor structure across the substrate), the features of the disclosure may inhibit associated difficulties with droplet control that might otherwise arise from such inhomogeneity. Preferably, the thickness of the passivation layer is in the range 50nm to 800nm, more preferably 300nm to 600nm. In some alternative embodiments, a non-passivating layer may be provided in place of the passivation layer.

In preferred embodiments, the thickness of each frame is less than 100nm, more preferably less than 50nm. Accordingly, the frame is relatively thin and does not substantially add to the overall thickness of the device.

In preferred embodiments, the passivation layer is formed of SiO₂. However, alternative arrangements may comprise a passivation layer formed of other materials, such as Si₃N₄ or Al₂O₃.

In some preferred embodiments, each frame is formed of gold. Alternatively the frame may be formed of another material, such as an oxide (e.g. SiO₂ or Al₂O₃), nitride (e.g. SiN, Si₃N₄ or AIN), a polymer or another metal (e.g. Al).

The sensor structure may comprise a magnetoresistive sensor (such as a giant magnetoresistive sensor). It may alternatively comprise an alternative magnetic sensor or any other kind of sensor.

The solution may be a "probe molecule" solution comprising probe molecules for coupling to the device surface. The device surface may be particularly functionalized to receive probes at certain locations, or in other embodiments may not require such processing. The droplet may alternatively or additionally comprise analyte.

### Brief Description of the Figures

An embodiment of the present disclosure will now be described with reference to the accompanying figures, in which:
Figure 1 illustrates a side view of a device according to the present disclosure with a droplet on its surface together with an expanded view of an interface point;
Figure 2 is a plan view of the device; and
Figure 3 illustrates potential configurations of the frame of the device.

### Detailed description

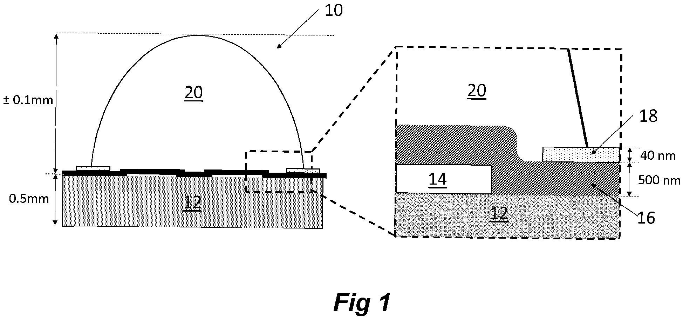

Referring to Figure 1, there is provided a device 10 comprising a substrate 12, a sensor structure 14, a passivation layer 16 and a frame 18. A droplet 20 of a biochemical solution is provided on the surface of the device 10.

Probe molecules may be provided in the droplet 20. These probe molecules may couple to the surface of the device 10. The probe molecules bind with particular molecules in a later-provided solution which have themselves been coupled to magnetisable particles. The presence or otherwise of the particular molecules in the solution can thus be inferred from the response when a magnetic field is applied in the region of the device surface. The sensor structure 14 detects this response.

The substrate 12 can be formed of any material suitable for the construction of integrated circuits, such as silicon, preferably monocrystalline silicon. The sensor structure 14 is disposed either directly or indirectly on the substrate 12 and may comprise a magnetic sensor, such as a magnetoresistive sensor (for example, a giant magnetoresistive sensor) and connecting current lines formed of aluminium, copper or gold, for example.

The sensor structure 14 may alternatively be another kind of sensor, such as an optical sensor, charge or mass sensors, or an electrochemical sensor. In general, these sensors have a non-negligible thickness, leading to a variation in the topography of the surface of the device and thus a potential dispersion of the droplet away from the site at which it is placed.

The passivation layer 16 is disposed directly or indirectly on the substrate 12 and sensor structure 14. The passivation layer 16 of the preferred embodiment is formed of a material such as SiO₂, Si₃N₄ or Al₂O₃. The thickness of the passivation layer 16 is 500nm.

The passivation layer 16 of the preferred embodiment has a substantially constant thickness, meaning that the topology of the chip surface varies between regions in which the sensor structure 14 is present and regions in which it is not. This could cause the droplet 20 to disperse in the absence of any other elements. However, the frame 18 maintains the boundaries of the droplet. The frame 18 is more hydrophobic than the passivation layer 16 (i.e. has a lower wettability) and as a result inhibits the dispersion of the droplet 20.

As can be seen from Figure 1, the frame 18 does not inhibit the spread of the droplet 20 through providing a physical barrier but instead through its material properties. The frame 18 may have a thickness less than the height of the droplet and/or less than the thickness of the sensor structure. In the preferred embodiment illustrated in Figure 1, the frame has a thickness of around 40nm, in comparison with a droplet height of approximately 0.1 mm.

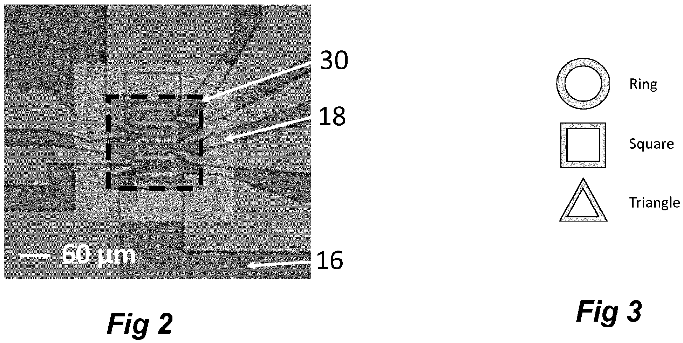

Figure 2 shows the device of Figure 1 from above. A sensor region 30 within the frame 18 can be seen from this Figure. The sensor structure 14 is disposed within this sensor region 30 and the frame 18 surrounds it. As mentioned previously, the frame 18 is more hydrophobic than the passivating layer 16 which forms the surface of the device 10 in areas in which the frame is not present. Therefore, when a droplet 20 is deposited within the sensor region 30 the frame 18 acts to prevent unwanted spreading to other regions of the device 10.

In the embodiment shown in Figure 2, the frame has a width of around 20-80um while the sensor region is square with a side length of 100-300um. The sensor region is generally large enough to receive a droplet, and may have, for example, a side length of 10um or more. Thus the area of the sensor region may be at least 100um² and in the embodiment shown is at least 10000um². Alternative arrangements of frame defining sensor regions with different geometries, such as rings or triangles can be seen in Figure 3.

Although Figures 1 and 2 illustrate a single sensor region 30 and droplet 20, it will be understood that the device 10 as a whole may comprise an array of similar structures. In particular, there may be a plurality of sensor structures 14 disposed within an associated sensor region 30 defined by an associated frame 18.

Variations and modifications will be apparent to the skilled person. Such variations and modifications may involve equivalent and other features which are already known and which may be used instead of, or in addition to, features described herein. Features that are described in the context of separate embodiments may be provided in combination in a single embodiment. Conversely, features which are described in the context of a single embodiment may also be provided separately or in any suitable sub-combination.

For example, while the above description relates to biological assays using magnetic sensing techniques, it will be understood that the principles can be applied to non-biological tests and/or the use of other types of sensors, such as optical sensors, charge sensors or electrochemical sensors, for example.

It should be noted that the term "comprising" does not exclude other elements or steps, the term "a" or "an" does not exclude a plurality, a single feature may fulfil the functions of several features recited in the claims and reference signs in the claims shall not be construed as limiting the scope of the claims. It should also be noted that the Figures are not necessarily to scale; emphasis instead generally being placed upon illustrating the principles of the present invention. Where ranges are disclosed, they should be considered to include their endpoints.

## Claims

1. A sensing device for receiving a droplet of solution, comprising
a substrate;
one or more sensor structures disposed above the substrate, each sensor structure being disposed within an associated sensor region of the device; and
one or more frames formed of a material, each frame surrounding an associated sensor region and having a second wettability lower than a first wettability of at least part of the surface of the device within the frame.

2. A sensing device comprising a plurality of sensor structures and a plurality of frames.

3. A sensing device according to claim 1 or claim 2, wherein each sensor region has an area of at least 100um², preferably at least 10000um².

4. A sensing device according to any one of the preceding claims, wherein the thickness of each frame is less than 100nm, preferably less than 50nm.

5. A sensing device according to any one of the preceding claims, further comprising a passivation layer.

6. A sensing device according to claim 5, wherein the passivation layer has a substantially constant thickness.

7. A sensing device according to claim 6, wherein the thickness of the passivation layer is in the range 50nm to 800nm, preferably 300nm to 600nm.

8. A sensing device according to claim 7, wherein the passivation layer is formed of SiO₂.

9. A sensing device according to any one of the preceding claims, wherein each frame is formed of gold.

10. A sensing device according to any one of the preceding claims, wherein the sensor structure comprises a magnetic sensor such as a giant magentoresistive sensor.

11. A method for locating a solution above a sensor structure, the method comprising:
providing a sensing device comprising:
a substrate;
one or more sensor structures disposed above the substrate, each sensor structure being disposed within an associated sensor region of the device; and
one or more frames, each frame surrounding a sensor region and being formed of a material having a second wettability lower than a first wettability of at least a portion of the surface of the device within the frame.
wherein the method further comprises depositing a droplet of the solution on the surface of the sensing device within each frame.

12. A method according to claim 11, wherein the sensing device comprises a plurality of sensor structures and a plurality of frames.

13. A method according to claim 11 or claim 12, wherein each sensor region has an area of at least 100um², preferably at least 10000um².

14. A method according to any one of claims 11 to 13, wherein the thickness of each frame is less than 100nm, preferably less than 50nm.

15. A method according to any one of claims 11 to 14, wherein the device further comprises a passivation layer.

16. A method according to any one of claims 15, wherein the passivation layer has a substantially constant thickness.

17. A method according to claim 16, wherein the thickness of the passivation layer is in the range 50nm to 800nm, preferably 300nm to 600nm.

18. A method according to any one of claims 15 to 17, wherein the passivation layer is formed of SiO₂.

19. A method according to any one of claims 11 to 18, wherein each frame is formed of gold.

20. A method according to any one of claims 11 to 19, wherein the sensor structure comprises a magnetic sensor such as a giant magnetorestive sensor.
